# EUROPEAN PATENT APPLICATION

(11) **EP 2 760 056 A2**
(43) Date of publication of application: **30.07.2014**
(21) Application number: 14152207.8
(22) Date of filing: 22.01.2014
(51) Int. Cl.: H01L 33/36, H01L 33/62

(54) **Package-free and circuit board-free led device and method for fabricating the same**

(30) Priority: 25.01.2013 TW 102102864
(71) Applicant: Wang, Chung-Lin, Hsinchu City 300 (TW)
(72) Inventor: Wang, Chung-Lin, Hsinchu City 300 (TW)
(74) Representative: Lang, Christian

(57) **Abstract**

The present invention discloses a package-free and circuit board-free LED device and a method for fabricating the same. The LED device is exempted from the semiconductor package substrate and the printed circuit board and comprises at least one LED chip having two electrodes able to directly connect with external wires and at least one chip unit. A DC power or an AC power is directly electrically connected with the two electrodes through wires to drive the LED device to emit light. The present invention minimizes device components and fabrication steps, effectively reduces cost and promotes reliability and yield.

## Description

### BACKGROUND OF THE INVENTION

### Field of the Invention

The present invention relates to an LED device, particularly to a package-free and circuit board-free LED device and a method for fabricating the same.

### Description of the Related Art

It is the principle of LED (Light Emitting Diode): while a forward current flows into a PN junction of semiconductors, the intrinsic characteristics of the semiconductors will induce the PN junction to emit light. As LED features durability, long service life, lightweightness, compactness, and low power consumption, and is free of harmful materials, such as mercury, it has been widely used in illumination industry.

In the earliest stage, an LED package structure normally has a chip installed on a lead frame, and an encapsulating resin covers the chip and a portion of the lead frame with the metallic leads of the lead frame exposed to function as external contacts. Then, the metallic leads of a plurality of LED package structures are connected with the metallic lines of a printed circuit board, whereby the LED package structures are electrically interconnected to form an LED array. However, it is hard to reduce the volume of the traditional LED package structure because of the original size of the LED structure. The traditional LED package structure can only dissipate heat via the metallic leads. However, the heat dissipation effect thereof is pretty limited.

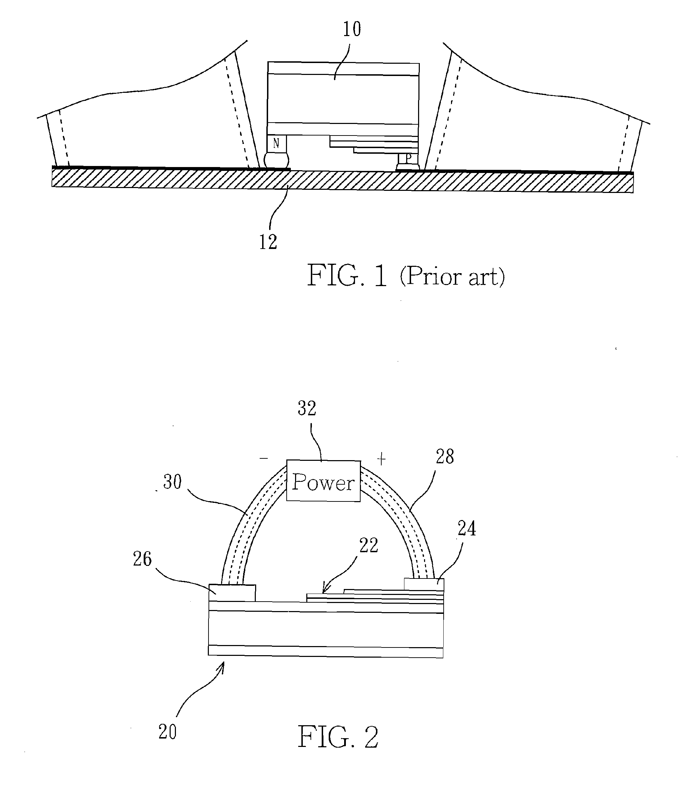

To solve the abovementioned problems, a Taiwan patent No.I281271 disclosed an LED device and a method for fabricating the same, wherein an unpackaged LED chip is directly connected with a printed circuit board (PCB) without using a package substrate. Refer to Fig.1. An unpackaged LED chip 10 is directly fixed to and electrically connected with a printed circuit board 12. The printed circuit board 12 has pre-fabricated circuit and is free of any substrate for semiconductor package. Thus is formed a package-free LED device. Although free of any package substrate, the prior-art LED device still needs a printed circuit board. Therefore, the prior art still needs a PCB fabrication process and a chip aligning and bonding process. Any extra process would affect the reliability and yield of elements and increase the cost and time of fabrication.

Accordingly, the present invention proposes a package-free and circuit board-free LED device and a method for fabricating the same to overcome the conventional problems.

### SUMMARY OF THE INVENTION

The primary objective of the present invention is to provide a package-free and circuit board-free LED device and a method for fabricating the same, wherein the LED (Light Emitting Diode) chip has two electrodes able to connect with external wires and at least one chip unit, and wherein a power source is directly electrically connected with the electrodes through wires to drive the LED chip to emit light, whereby the present invention is exempted from the semiconductor package substrate and the printed circuit board, minimizing device components and fabrication steps, effectively reducing cost and promoting reliability and yield.

Another objective of the present invention is to provide a package-free and circuit board-free LED device and a method for fabricating the same, wherein two electrodes able to connect with external wires and a plurality of chip units are directly fabricated on the LED chip, and wherein the chip units are connected in series, or in parallel, or in series and parallel according to various requirements, whereby the present invention has higher application flexibility.

A further objective of the present invention is to provide a package-free and circuit board-free LED device and a method for fabricating the same, wherein a heat dissipation plate is directly arranged on the LED device to optimize the heat dissipation effect.

To achieve the abovementioned objectives, the present invention proposes a package-free and circuit board-free LED device, which comprises an LED chip having two electrodes able to connect with external wires and at least one chip unit, wherein a photolithographic technology and chip processes are used to fabricate said electrodes, and wherein a DC (Direct Current) power or an AC (Alternating Current) power is directly electrically connected with the two electrodes through wires to drive the LED device to emit light.

The present invention also proposes a method for fabricating a package-free and circuit board-free LED device, which comprises steps: providing an LED chip having two electrodes able to directly connect with external wires and at least one chip unit; and directly electrically connecting a DC power or an AC power with the two electrodes through wires to drive the LED device to emit light.

Below, the embodiments are described in detail in cooperation with the attached drawings to make easily understood the objectives, technical contents, characteristics and accomplishments of the present invention.

### BRIEF DESCRIPTION OF THE DRAWINGS

- Fig.1: schematically shows a conventional unpackaged LED chip, which is directly aligned to and bonded to PCB without using a package substrate, and then connected with PCB through wires;
- Fig.2: schematically shows the structure of an LED chip having two electrodes able to connect with external wires and a chip unit according to one embodiment of the present invention;
- Fig.3: schematically shows the structure of an LED chip having two electrodes able to connect with external wires and a plurality of chip units connected in series according to one embodiment of the present invention; and
- Fig.4: schematically shows the structure of an LED wafer having two electrodes able to connect with external wires and a plurality of chip units connected in series and parallel according to one embodiment of the present invention.

### DETAILED DESCRIPTION OF THE INVENTION

In fabricating an LED chip, an LED epitaxial layer having a PN junction is formed on a substrate, such as a substrate made of gallium nitride, sapphire, gallium phosphide, or gallium arsenide. Further, two electrodes are formed on appropriate positions, supplying sufficient voltage drop to the LED epitaxial layer. Thereby, the PN junction of the LED epitaxial layer generates and emits light. The present invention uses a photolithographic technology and chip processes to fabricate two electrodes able to connect with external wires and at least one chip unit on an LED chip or even an uncut LED wafer. The present invention can directly light up the chip unit via connecting wires with the electrodes and supplying power to the electrodes without using any PCB fabrication process, package process or aligning/bonding process.

Refer to Fig.2 for the structure of an LED device according to one embodiment of the present invention. The package-free and circuit board-free LED device of the present invention comprises at least one LED chip 20, which is a bare chip having never been packaged. The LED chip 20 has at least one chip unit 22. A photolithographic technology and chip processes are used to fabricate two electrodes 24 and 26 for connecting with external wires. The two electrodes 24 and 26 are directly connected with a power 32 through two external wires 28 and 30. The power 32 can be a DC power or an AC power. Then, electric power is supplied to the LED chip 20 to light up the LED chip 20. According to practical requirement, the two electrodes 24 and 26 on the chip unit 22 are fabricated photolithographically in the semiconductor process of fabricating the LED chip or fabricated via dispensing conductive glue on the predetermined electrode areas after the semiconductor process of fabricating the LED chip.

Below is described the process of fabricating the LED device according to one embodiment of the present invention. Refer to Fig.2 again. Firstly, provide an unpackaged LED chip 20 having at least one chip unit 22. The chip unit 22 has two electrodes 24 and 25 able to connect with external wires. The electrodes 24 and 26 are fabricated in a photolithographic technology and chip processes. Next, use wires to electrically connect the positive electrode and the negative electrode of a power 32 with the electrodes 24 and 26. Thus, the fabrication of the LED device of the present invention is completed.

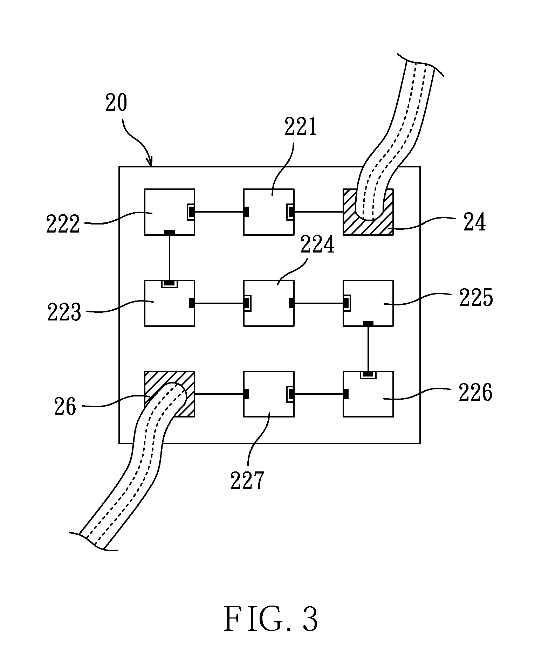

In addition to the abovementioned LED device only having a single chip unit, the present invention also proposes an LED device fabricated in a photolithographic technology and containing a plurality of chip units connected in series, or in parallel, or in series and parallel. Refer to Fig.3. The LED chip 20 has a plurality of chip units 221-227 fabricated in a photolithographic technology and chip processes and arranged into an array. The chip units 221-227 are connected in series sequentially. Some of the chip units 221-227 respectively have electrodes 24 and 26 able to connect with external wires. In Fig.3, the chip unit 221 has the electrode 24, and the chip unit 227 has the electrode 26. The electrodes 24 and 26 are directly connected with wires, and the wires are connected with a power source. The two electrodes able to connect with an external circuit are fabricated in a photolithographic technology and chip processes also.

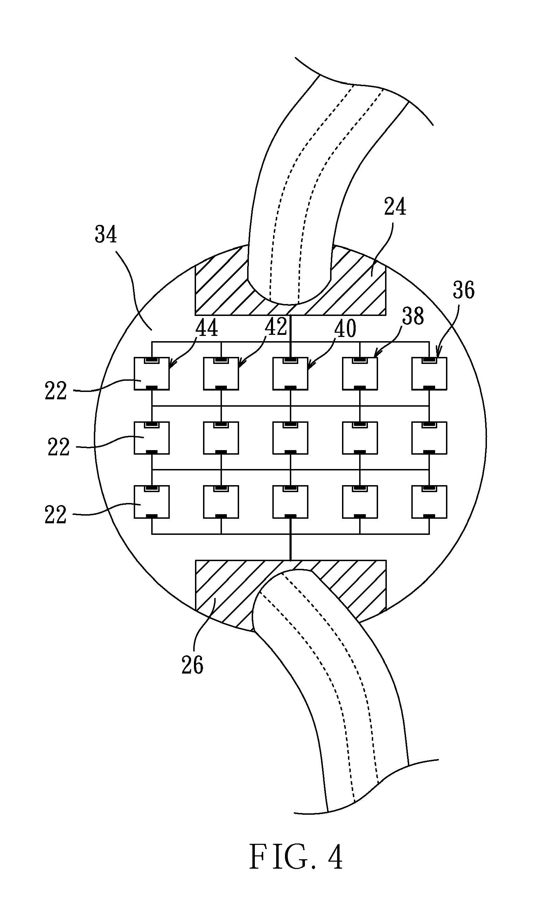

In some embodiments, the LED chip is an uncut LED wafer. Refer to Fig.4. A photolithographic technology and chip processes are used to fabricate an LED wafer 34 into electrodes 24 and 26 able to connect with external wires and a plurality of chip units 22 arranged into an array. In the embodiment shown in Fig.4, each three chip units 22 are connected in series to form chip unit strings 36, 38, 40, 42 and 44. Further, the chip unit strings 36, 38, 40, 42 and 44 are connected in parallel with the electrodes 24 and 26. A power source is connected with the electrodes 24 and 26 through wires to light up the chip unit strings 36, 38, 40, 42 and 44.

In order to enhance the heat dissipation effect of the LED device, the present invention arranges a heat dissipation plate on the bottom of the LED chip or the LED wafer of any embodiment described above. The LED device of the present invention is applicable to illumination devices. The package-free and circuit board-free LED device of the present invention can be directly mounted on a lamp seat to form an illumination device in cooperation with a lamp cover and a switch. In order to provide different colors of light, a fluorescent layer is sprayed on or coated on the surface of the chip unit. Alternatively, a fluorescent film is stuck to the surface of the chip unit. Thereby, the LED device of the present invention can emit light having a specified color.

The present invention is exempted from the semiconductor package substrate and the printed circuit board, minimizing device components and fabrication steps, effectively reducing cost and promoting reliability and yield. The present invention directly forms electrodes able to connect with external wires and a plurality of chip units on the package-free and circuit board-free LED device, and connects the chip units in series, or in parallel, or in series and parallel. In the present invention, the number and connection configuration of the chip units can vary according to various requirements. Therefore, the present invention has higher application flexibility.

The embodiments described above are to demonstrate the technical thought and characteristics of the present invention to enable the persons skilled in the art to understand, make, and use the present invention. However, these embodiments are not intended to limit the scope of the present invention. Any equivalent modification or variation according to the characteristic or spirit of the present invention is to be also included within the scope of the present invention.

## Claims

1. A package-free and circuit board-free light emitting diode device comprising at least one light emitting diode (LED) chip, which comprises: an LED chip having two electrodes able to connect with external wires and at least one chip unit, wherein a photolithographic technology and chip processes are used to fabricate said electrodes, and wherein a DC power or an AC power is directly electrically connected with said two electrodes through said external wires to drive said LED device to emit light.

2. The package-free and circuit board-free light emitting diode device according to claim 1, wherein a plurality of said chip units form on said LED chip by a photolithographic technology and chip processes.

3. The package-free and circuit board-free light emitting diode device according to claim 2, wherein said chip units connect each other in series, or in parallel, or in series and parallel.

4. The package-free and circuit board-free light emitting diode device according to claim 1, wherein said LED chip is an uncut LED wafer.

5. The package-free and circuit board-free light emitting diode device according to claim 1, wherein said two electrodes able to connect with external wires are directly photolithographically fabricated in a process of fabricating said LED chip or fabricated via dispensing conductive glue after said process of fabricating said LED chip.

6. A method for fabricating a package-free and circuit board-free light emitting diode device, comprising steps:
providing a light emitting diode (LED) chip, wherein a photolithographic technology and chip processes are used to fabricate two electrodes able to directly connect with external wires and at least one chip unit on said LED chip; and
electrically connecting a power with said two electrodes through said external wires to drive said LED device to emit light.

7. The method for fabricating a package-free and circuit board-free light emitting diode device according to claim 6, wherein a photolithographic technology and chip processes is used to fabricate a plurality of said chip units on said LED chip, and said chip units connect each other in series, or in parallel, or in series and parallel.

8. The method for fabricating a package-free and circuit board-free light emitting diode device according to claim 6, wherein said two electrodes able to connect with external wires are directly photolithographically fabricated in a process of fabricating said LED chip or fabricated via dispensing conductive glue after said process of fabricating said LED chip.

9. The method for fabricating a package-free and circuit board-free light emitting diode device according to claim 6, wherein said LED chip is an uncut LED wafer.
